# EUROPEAN PATENT SPECIFICATION

(11) **EP 0 443 296 B1**
(45) Date of publication and mention of the grant of the patent: **04.08.1999**
(21) Application number: 90830062.7
(22) Date of filing: 20.02.1990
(51) Int. Cl.: H01L 21/285

(54) **Process for obtaining multilayer metallization of the back of a semiconductor substrate**
Verfahren zur mehrschichtigen Metallisierung der Rückseite einer Halbleiterscheibe
Procédé pour la métallisation multi-couches de la face arrière d'un substrat semi-conducteur

(43) Date of publication of application: 28.08.1991
(73) Proprietor: STMicroelectronics S.r.l., 20041 Agrate Brianza (Milano) (IT)
(72) Inventor: Santangelo, Antonello, I-95032 Belpasso CT (IT); Magro, Carmelo, I-95125 Catania CT (IT); Lanza, Paolo, I-96010 Cassaro SR (IT)
(74) Representative: Arena, Giovanni

(56) References cited:
- EP-A- 0 012 324
- FR-A- 2 531 106
- US-A- 4 135 292
- IBM TECHNICAL DISCLOSURE BULLETIN, vol. 24, no. 7A, December 1981, page 3453, New York, US; W. RAUSCH et al.: "Palladium silicide contact resistance stabilization by ion implantation"
- JAPANESE JOURNAL OF APPLIED PHYSICS. SUPPLEMENTS, 15TH CONFERENCE ON SOLID STATE DEVICES AND MATERIALS, Tokyo, 1983, pages 11-14; K. ISHIBASHI et al.: "Study on formation of solid-phase-epitaxial CoSi2 films and patterning effects"
- IBM Journal of Research and Development, Vol.31, Nr.6, November 1987, pages 608-616

## Description

This invention refers to a process for obtaining multilayer metallization of the back of a semiconductor substrate.

Numerous semiconductor electron devices use the back of the substrate, on which they are constructed, as an electric terminal. This area must therefore be metallized in order to enable the electrical connection and the M-S (Metal Semiconductor) contact must have a sufficiently low specific contact resistance as to ensure that no appreciable voltage drops occur when the current passes through (ohmic contact).

In the majority of cases, the metallization on the back must also ensure the possibility of welding the latter onto a metal support which forms part of the package of the finished device and also acts as a heatsink.

In order to simultaneously guarantee these characteristics, very often several layers of metal are deposited on the back, with the first layer of metal having a low barrier height for the underlying semiconductor. Moreover, since one of the main factors on which the specific contact resistance of an M-S junction depends, consists of the concentration of electrically active dopant present in correspondence with the M-S interface, very often the surface of the semiconductor is enriched with dopant before the layers of metal are applied.

The most widely used methods of enrichment consist of predeposition and ion implantation of the dopant. The first method calls for very high temperatures (of over 900 °C).

With the second method, if the ion bombardment has produced a surface layer of amorphous material, it is necessary to carry out the subsequent annealing at a temperature higher than 500-550 °C in the case of silicon, with a subsequent epitaxial regrowth in the solid phase ("SPE") of the damaged layer and activation of the implanted species. For different purposes and in presence of an overlaying pure aluminum layer, the silicon surface amorphization can be useful to solve a well known problem relevant to this metal (see EP-A-0012324). The disordered layer can be consumed by aluminum during a thermal process at temperature below 500 °C to produce a very flat Al/Si interface. In any case if the ion bombardment has not caused amorphization, it is necessary to use a higher annealing temperature to activate the implanted species.

With both the first and the second method, the temperature at which the thermal processes are carried out proves to be harmful for the devices on the front of the wafer.

On the other hand, since it is necessary, upon completion of the front of the wafer, to reduce the thickness of the substrate by means of an appropriate finishing process, the rear surface can only be enriched after completion of the devices present on the front. It is clear therefore that the known tecniques for enriching the surface of the semiconductor are of little help in solving this problem.

A process for stabilizing palladium-silicide contact resistence by ion implantation is described in IBM Technical Disclosure Bulletin, Vol.24. No.7A, Dec. 1981, page 3453. The process provide surface implanting of argon ions and consequent creation of an amorphous silicon layer on the contact surface, followed by a deposition of a palladium layer and than by an annealing at 400 °C for 20 minutes, with consequent formation of palladium silicide in corrispondence of the amorphous silicon layer.

A method for fabricating an integrated circuit aluminum-silicon contact and for avoiding migration of metal into the underlaying layers during the deposition of the metal layer is described in US-A-4135292. According to the same before the metal deposition an amorphous region is formed in the contact areas by ion implantation with the consequence that during the following metal deposition the amorphized region partially forms an alloy with the metal.

The main scope of this invention is to provide a process for multilayer metallization of the back of a semiconductor substrate which offers a satisfactory M-S ohmic contact and in particular to increase the concentration of dopant present on the surface of the semiconductor and at the same time keep the temperature and duration of the annealing treatment within values which rule out the possibility of alteration of other structural and functional characteristics of the semiconductor device.

The process according to the invention concerns a metallization process of the back of a silicon semiconductor substrate, obtained by depositing a sequence of metal layers after ion implantation of dopant on the surface of the semiconductor which acts as an interface with the first layer of metal, said ion implantation of dopant being carried out in such a way as to amorphize the surface of the semiconductor substrate, and is characterized by the fact that said ion implantation is followed by the deposition of one or more layers of metal of the aforesaid series, the metal of the first layer being titanium and then by thermal annealing under vacuum or in an inert atmosphere, at a temperature and for a period sufficient for regrowth of the amorphized layer and activation of the implanted species, said temperature being lower than 500 °C and said period being shorter than 60 minutes, and lastly by the deposition of the remaining metal layers of the series.

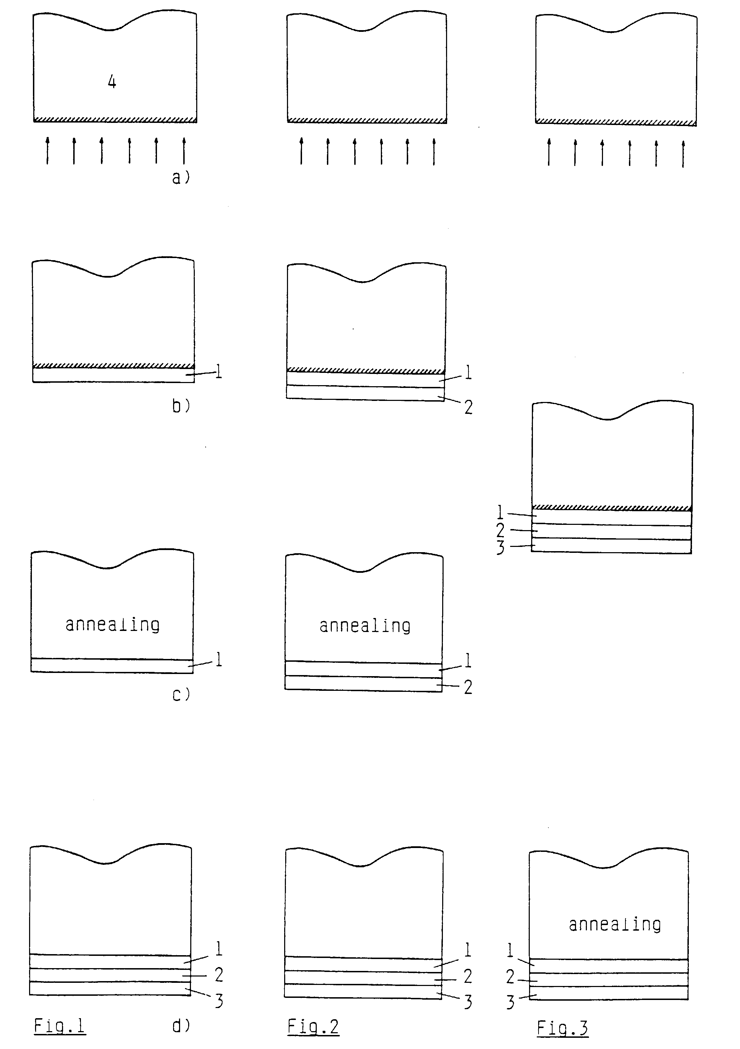

The features of the invention will be more clearly evident from the following description of a number of non-restrictive exemplificative embodiments, with reference to the accompanying drawings, in which figures 1, 2 and 3 respectively show a first, a second and a third embodiment of the process according to the invention.

The summary of the entire process according to this invention is as follows:
1) Ion implantation of the rear surface of the wafers, so as to amorphize the surface of the semiconductor. The process is carried out before depositing the sequence of metal layers. The implanted species, when activated, must have an electrical behaviour homologous to that of the pre-existing dopant. The dose must be such as to ensure a satisfactory M-S ohmic contact at the end of the metallizing process. With N type silicon, good results are obtained by implanting arsenic at energies E lower than 10 KeV, so as to localize the implanted species as close as possible to the M-S interface (with E = 5 KeV and doses equal to 2·10¹⁴ atoms/cm² the maximum concentration of the implanted specied is obtained at a distance of approximately 0,5·10⁻² µm from the surface). This also reduces the thickness of the amorphized layer produced and, consequently, the annealing time.
2) Deposition on the back of the substrate of one or more layers of metal in a system suitable for sequential deposition of several layers of metal and capable of heating the substrates under vacuum or in an inert atmosphere.
   Since at the end of the entire metallizing process the surface of the semiconductor will have been enriched with the appropriate species of dopant, the first layer of metal can be chosen on the basis of criteria which need not necessarily be electrical. These criteria may be better adhesion between the first layer and the semiconductor, or a better thermal expansion coefficient and less induced stress, or productivity, etc..
3) Annealing under vacuum (preferably at a pressure ≤ 1.33·10⁻⁴ Pa [10⁻⁶ Torr]) or in an inert atmosphere (preferably at a pressure ≤ 4 Pa [30·10⁻³ Torr]), carried out in the same deposition system at a temperature considerably lower than 500 °C and for a period considerably shorter than 60 minutes (for example, ≤ 400 °C and 30 minutes respectively). In the case of silicon in particular, if the energy of the previously mentioned system is around 5 KeV, approximately 30 minutes of annealing at a temperature of approximately 375 °C are sufficient for regrowth of the amorphized layer and activation of the implanted species. The heating can be achieved, for example, by means of special lamps powered by means of a thermostatically-controlled system.
4) Sequential deposition of the remaining metal films. The last layers are very often necessary in order to ensure the possibility of welding the finished device onto a metal support by means of suitable low-melting metal alloys. Said support can form part of the final package of the device or be an electrode of a hybrid circuit. The remaining metal films can be deposited in sequence on the first metal layers and, consequently, before the annealing, which can therefore become the last step of the process.
   For some sequences of metals, depositing several metal layers in the series, or even the entire series, before annealing improves the adhesion between the various films.

A non-restrictive example is given in the following description of a process for metallizing a <100> N type silicon substrate 4 doped with approximately 2·10¹⁸ atoms of antimony/cm³ (see Fig.1).

First, an arsenic implantation is carried out using a dose of approximately 10¹⁴ atoms/cm³ and an energy of approximately 5 KeV (Fig. 1a), so as to produce an amorphized layer on the surface (layer indicated in the figure by the broken line). The substrate is then placed in an e-gun type evaporator equipped with at least three interchangeable crucibles and provided with a thermoregulated lamp heating system. After pumping to create a vacuum (with a pressure of ≤ 1,33·10⁻⁴ Pa [10⁻⁶ Torr]), a first layer 1 of approximately 100 nm of titanium is deposited (Fig. 1b). This is followed by a heating cycle (still under high vacuum) at 375 °C for approximately thirty minutes (Fig. 1c). When the temperature has dropped slightly a further layer of approximately 350 nm of nickel and a film 3 of approximately 30 nm of gold are deposited (Fig. 1d). The entire process ensures good metallurgical characteristics and specific contact resistance values lower than approximately 10⁻⁴ ohm·cm² (without the process according to this invention, there is very little likelihood of the specific contact resistance dropping below approximately 2·10⁻² ohm·cm²). The annealing step, which in the process of figure 1 takes place after deposition of the first metal layer, can be carried out after the second layer has been deposited (Fig.2) or even after all the layers have been deposited (Fig.3).

One possible explanation for the main advantage achieved with the process according to the invention is that, in addition to producing the metal electrode of the M-S contact, the deposition of the first metal film carried out after the implantation and before the annealing treatment, also has the important function of accelerating and greatly facilitating the regrowth of the previously amorphized crystal, when the system is heated during the annealing, which can consequently be carried out at considerably low temperatures and for limited periods of time.

In addition to the previously mentioned main advantages, the following further advantages are also achieved:
- The possibility of carrying out the annealing in the same system in which the metal layers are deposited, in addition to reducing the times and cost of the necessary equipment, improves the physical properties and reliability of the metal on the back of the substrate.
- Carrying out the annealing under high vacuum conditions or in an inert atmosphere prevents oxidation or contamination of the last metal layer already deposited, thus making it possible to obtain a better interface with the metal layer deposited after the annealing;
- The possibility of considerably reducing the specific M-S contact resistance makes it possible not only to improve the electrical characteristics of the semiconductor device, but also their reproducibility; moreover, the choice of the first layer of metal is less restricted by problems of specific contact resistance thus offering the possibility of satisfying other requirements (satisfactory adhesion between the first layer and the substrate, reduction of induced stress, process economy, etc.).

## Claims

1. Process for metallizing the back of a silicon semiconductor substrate, by depositing a series of metal layers, after ion implantation of dopant on the surface of the semiconductor which acts as an interface with the first layer of metal, said ion implantation of dopant being carried out in such a way as to amorphize the surface of the semiconductor substrate, characterized by the fact that said ion implantation is followed by:
- the deposition of one or more layers of metal of the aforesaid series, the metal of the first layer being titanium, and then by
- a thermal annealing under vacuum or in an inert atmosphere, at a temperature and for a period sufficient for regrowth of the amorphized layer and activation of the implanted species, said temperature being lower than 500 °C and said period being shorter than 60 minutes, and lastly by
- the deposition of the remaining metal -layers of the series.

2. Process as claimed in Claim 1, characterized by the fact that the deposition of the metal layers and the thermal annealing are carried out in the same equipment suitable for sequential deposition of several layers of metal on a semiconductor substrate and for heating the same substrate under vacuum or in an inert atmosphere.

3. Process as claimed in Claim 1, characterized by the fact that the thermal annealing is carried out in a high-vacuum atmosphere with a pressure of ≤ 1,33·10⁻⁴ Pa (10⁻⁶ Torr), at a temperature of ≤ 400 °C and for a period of ≤ 30 minutes.

4. Process as claimed in Claim 1, characterized by the fact that the thermal annealing is carried out in an atmosphere consisting of inert gas at a pressure of ≤ 4 Pa (30·10⁻³ Torr), at a temperature of ≤ 400 °C and for a period of ≤ 30 minutes.

5. Process as claimed in Claim 1, characterized by the fact that the substrate is of N type, the implanted dopant is arsenic and the implantation energy is ≤ 10 KeV.

6. Process as claimed in Claim 5, characterized by the fact that the dose of arsenic implanted is 2·10¹⁴ atoms/cm², the implantation energy is 5 KeV, and the thermal annealing is carried out at a temperature of 375 °C for a period of 30 minutes.

## Patentansprüche

1. Verfahren zur Metallisierung der Rückseite eines Silizium-Halbleitersubstrats durch Ablagern einer Reihe von Metallschichten nach Ionenimplantation eines Dotierstoffes auf die Oberfläche des Halbleiters, welcher als Zwischenfläche mit der ersten Metallschicht dient, wobei die Ionenimplantation des Dotierstoffes derart ausgeführt wird, daß die Oberfläche des Halbleitersubstrats amorph wird, **dadurch gekennzeichnet,**
daß auf die Ionenimplantation folgt:
- die Ablagerung einer oder mehrerer Metallschichten auf die obengenannte Reihenfolge, wobei das Metall der ersten Schicht Titan ist, und dann,
- eine thermische Wärmebehandlung unter Vakuum oder in einer inerten Atmosphäre bei einer Temperatur und für einen Zeitraum, die ausreichen, um die amorph gewordene Schicht neu wachsen zu lassen und das implantierte Material zu aktivieren, wobei die Temperatur niedriger als 500°C und die Zeitdauer kürzer als 60 Minuten ist, und schließlich
- die Ablagerung der restlichen Metallschichten auf die Reihefolge.

2. Verfahren nach Anspruch 1, **dadurch gekennzeichnet,** daß die Ablagerung der Metallschichten und die thermische Wärmebehandlung in derselben Vorrichtung ausgeführt werden, welche sich zur aufeinanderfolgenden Ablagerung mehrerer Metallschichten auf einem Halbleitersubstrat und zum Aufheizen desselben Substrats unter Vakuum in einer inerten Atmosphäre eignet.

3. Verfahren nach Anspruch 2, **dadurch gekennzeichnet,** daß die thermische Wärmebehandlung in einer Hoch-Vakuumatmosphäre mit einem Druck von ≤ 1,33 x 10⁻⁴ Pa (10⁻⁶ Torr) und bei einer Temperatur von ≤ 400°C für einen Zeitraum von ≤ 30 Minuten ausgeführt wird.

4. Verfahren nach Anspruch 1, **dadurch gekennzeichnet,** daß die thermische Wärmebehandlung in einer aus inertem Gas bestehenden Atmosphäre bei einem Druck von ≤ 4 Pa (30 x 10⁻³ Torr), bei einer Temperatur von ≤ 400°C und für einen Zeitraum von ≤ 30 Minuten durchgeführt wird.

5. Verfahren nach Anspruch 1, **dadurch gekennzeichnet**, daß das Substrat N-leitend ist, das implantierte Dotiermittel Arsen ist und die Implantationsenergie ≤ 10 KeV beträgt.

6. Verfahren nach Anspruch 5, **dadurch gekennzeichnet,** daß die Dosis des implantierten Arsens 2 x 10¹⁴ Atome/cm² ist, die Implantationsenergie 5 KeV beträgt und die thermische Wärmebehandlung bei einer Temperatur von 375°C für einen Zeitraum von 30 Minuten ausgeführt wird.

## Revendications

1. Procédé de métallisation de la face arrière d'un substrat semiconducteur en silicium par dépôt d'une succession de couches métalliques, après implantation ionique d'un dopant à la surface d'un semiconducteur qui agit comme interface avec la première couche métallique, l'implantation ionique de dopant étant effectuée de façon à amorphiser la surface du substrat semiconducteur, caractérisé en ce que ladite implantation ionique est suivie par les étapes suivantes :
dépôt d'une ou plusieurs couches métalliques de la succession susmentionnée, le métal de la première couche étant du titane,
recuit thermique sous vide ou sous atmosphère inerte, à une température et pendant une durée suffisante pour faire recroître la couche amorphisée et activer l'espèce implantée, la température étant inférieure à 500°C et la durée étant inférieure à 60 minutes, et
dépôt des couches métalliques restantes de la succession.

2. Procédé selon la revendication 1, caractérisé en ce que le dépôt des couches métalliques et le recuit thermique sont effectués dans le même équipement propre au dépôt séquentiel de plusieurs couches métalliques sur un substrat semiconducteur et au chauffage du même substrat sous vide ou sous atmosphère inerte.

3. Procédé selon la revendication 1, caractérisé en ce que le recuit thermique est effectué sous un vide élevé à une pression inférieure ou égale à 1,33.10⁻⁴ Pa (10⁻⁶ Torr), à une température inférieure ou égale à 400°C, et pendant une durée inférieure ou égale à 30 minutes.

4. Procédé selon la revendication 1, caractérisé en ce que le recuit thermique est effectué sous une atmosphère consistant en un gaz inerte à une pression inférieure ou égale à 4 Pa (30.10⁻³ Torr) à une température inférieure ou égale à 400°C et pendant une durée inférieure ou égale à 30 minutes.

5. Procédé selon la revendication 1, caractérisé en ce que le substrat est de type N, le dopant implanté est de l'arsenic, et l'énergie d'implantation est inférieure ou égale à 10 keV.

6. Procédé selon la revendication 5, caractérisé en ce que la dose d'arsenic implantée est de 2.10¹⁴ atomes/cm², l'énergie d'implantation est de 5 KeV, et le recuit thermique est effectué à température de 375°C pendant une durée de 30 minutes.
